(19) Europäisches Patentamt / European Patent Office / Office européen des brevets

(11) **EP 1 835 377 A2**

(12) **EUROPEAN PATENT APPLICATION**

(43) Date of publication:
**19.09.2007 Bulletin 2007/38**

(51) Int Cl.:
***G06F 1/20*** (2006.01)

(21) Application number: **06253053.0**

(22) Date of filing: **13.06.2006**

| | |
|---|---|
| (84) Designated Contracting States:<br>**AT BE BG CH CY CZ DE DK EE ES FI FR GB GR HU IE IS IT LI LT LU LV MC NL PL PT RO SE SI SK TR**<br>Designated Extension States:<br>**AL BA HR MK YU** | (72) Inventor: **Urita, Kenji**<br>**c/o Fujitsu Limited**<br>**Kawasaki-shi**<br>**Kanagawa 211-8588 (JP)** |
| (30) Priority: **17.03.2006 JP 2006073682** | (74) Representative: **Fenlon, Christine Lesley et al**<br>**Haseltine Lake**<br>**Lincoln House**<br>**300 High Holborn**<br>**London WC1V 7JH (GB)** |
| (71) Applicant: **Fujitsu Ltd.**<br>**Kawasaki-shi, Kanagawa 211-8588 (JP)** | |

(54) **Cooling function monitoring apparatus**

(57)    A relationship between an operating rate and a temperature of a metal part when a fan is in a normal state is stored in advance, a temperature of a heat-generating part and a temperature of a reference point are actually measured in an operation to designate a temperature of the heat-generating part, and it is determined that a cooling capability deterioration state is set when the actually measured temperature of the heat-generating part is higher than an estimated temperature by a predetermined threshold value or higher.

Fig. 7

EP 1 835 377 A2

**Description**

BACKGROUND OF THE INVENTION

1. Field of the Invention

The present invention relates to a device having a heat-generating part which generates heat in operation and a fan which generates an air flow to air-cool the heat-generating part, a cooling function monitoring apparatus which monitors a cooling function of the fan, and a fan deterioration monitoring program storing medium in which a fan deterioration monitoring program for giving a function of monitoring deterioration of the fan to the device is stored.

2. Description of the Related Art

As previously-proposed when a heat-generating part which generates heat in operation must be mounted in a device, an arrangement position of the heat-generating part in the device is schemed, or, if the cooling is not satisfied by scheming the arrangement position, the heat-generating part is cooled by an air flow generated around the heat-generating part.

For example, in a personal computer, heat generation from an LSI constituting the circuit of a CPU is high. The upper-limit temperature of operation guarantee of the LSI is not too high, for example, about 95°C. For this reason, a heat-radiating fin for cooling is fixed to the LSI, and an air flow is generated by a fan to air-cool the LSI.

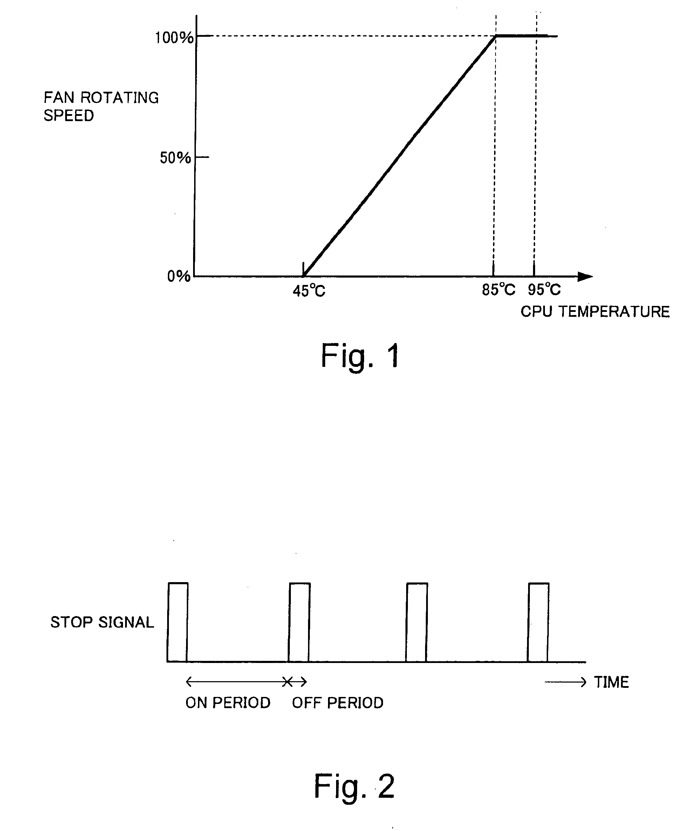

FIG. 1 is a graph showing a relationship between a temperature of a CPU and a rotating speed of a fan.

In this case, as an example, the fan is stopped when the temperature of the CPU is 45°C or less, and the fan is full rotated with all its strength (100%). The operation guarantee temperature of the CPU is set to 95°C.

Since the fan also consumes electric power, the fan approaches the end of its lifetime with its rotation. The rotation is suppressed as much as possible, and the fan is rotated at a necessary rotating speed according to the necessity of air-cooling to generate a necessary air flow.

A problem posed here is the following phenomenon. That is, although sufficient air-cooling can be obtained in a new device, when the device is aged, sufficient air-cooling cannot be obtained by rotation of the fan. As one of causes of the phenomenon, the following point is cited. That is, dust or dirt gradually attaches around the fan while the device is being used, a sufficient air flow is not generated even though the fan is rotated at a predetermined rotating speed, and sufficient air cooling cannot be achieved.

In a CPU, in order to prevent the temperature from increasing over an operation guarantee temperature, when the temperature almost exceeds the operation guarantee temperature, throttling which periodically stops the CPU in a short cycle is performed.

FIG. 2 is a diagram expressing throttling of a CPU.

When a temperature becomes excessively high, a stop signal is output to the CPU in a short cycle, the CPU stops for an OFF period in which the stop signal is received, and the CPU operates for an ON period set between the OFF periods. When the throttling is performed, although the CPU can be suppressed from increasing in temperature, a processing speed of the CPU decreases.

Dust or dirt attaches around a fan not to achieve sufficient air-cooling. As a result, when the throttling is performed, since the fan is rotated, the CPU operates the device at a low processing speed of the CPU without detecting that the low processing speed is caused by the dust or dirt. When the temperature further increases and the CPU is stopped, a user considers that the device is seriously broken down without knowing the defective fan, and then the user may be compelled to replace the device with a new device or to ask a service person to fix the device.

Various procedures to determine eterioration of a fan have been proposed.

For example, Japanese Patent Application Laid-open No. 3-203395 proposes that an ambient temperature is measured to determine deterioration of a fan on the basis of the ambient temperature.

Japanese Patent Application Laid-open No. 2004-27987 proposes that a reduction in rotating speed of the fan is regarded as deterioration of a fan.

Furthermore, Japanese Patent Application Laid-open No. 2002-58280 proposes that an operation situation of a motor is stored to make it easy to analyze a failure.

An increase in temperature when a heat-generating part such as a CPU operates is caused by not only deterioration of a fan but also an influence of an environmental temperature of a device in which the heat-generating part is mounted at that time. For example, when an ambient temperature of 40°C is regarded as deterioration of the fan, the device has a margin of 15°C when the environmental temperature is 25°. Even though the ambient temperature increases to 35°C due to the influence of a near heat-generating part, deterioration of the fan is not detected. When the environmental temperature is 35°C, the ambient temperature increases to about 45°C, and deterioration of the fan is determined although the fan is not defected.

Therefore, in the proposition of Japanese Patent Application Laid-open No. 3-203395 in which an ambient temperature is measured to detect deterioration of the fan, deterioration of the fan cannot be correctly detected.

Japanese Patent Application Laid-open No. 2004-27987 proposes that deterioration of a fan is detected by a rotating speed of the fan. Deterioration of a fan can be detected by employing the proposal only when the rotating speed of the fan is always constant. Even though dust or dirt attaches around the fan to deteriorate cooling capacity, deterioration (deterioration of air-flow generating capability) of the fan cannot be detected when the rotating speed of the fan is normal.

Japanese Patent Application Laid-open No. 2002-58280 checks a history of rotation of a fan when a failure occurs in the device to make it easy to analyze the failure, and is not relate to deterioration of the fan.

## SUMMARY OF THE INVENTION

Accordingly, it is desirable to provide a device having a capability of correctly detecting deterioration of an air-flow generating capability (air-cooling capability) of a fan, a cooling function monitoring apparatus having a capability of correctly detecting deterioration of a cooling function of a fan, and a fan deterioration monitoring program storing medium in which a fan deterioration monitoring program which gives the capability to the device is stored.

According to an embodiment of a first aspect of the present invention, there is provided a device having a heat-generating part which generates heat in operation and a fan which generates an air flow to air-cool the heat-generating part, including:

a storing section in which a relationship between an operating rate of the heat-generating part and a temperature of the heat-generating part when the fan is in a normal state is stored;

a temperature sensor which measures a temperature of the heat-generating part and a temperature of a reference point separated from the heat-generating part;

a temperature estimating section which calculates an estimated temperature of the heat-generating part corresponding to a current operating rate of the heat-generating part on the basis of the relationship stored in the storing section and an actually measured temperature of the reference point;

a determining section which determines whether a cooling capability deterioration state is set on the basis of an actually measured temperature of the heat-generating part measured by the temperature sensor and the estimated temperature calculated by the temperature estimating section; and

a warning section which gives a warning to a user in response to a determination that the cooling capability deterioration state is set, the determination being made by the determining section.

In the device according to an embodiment of the present invention, a relationship between an operating rate of the heat-generating part and a temperature of the heat-generating part when the fan is in a normal state is stored, the temperature of the heat-generating part and the temperature of the reference point are actually measured to estimate a temperature of the heat-generating part, and it is determined whether a cooling capability deterioration state is set on the basis of the actually measured temperature of the heat-generating part and the estimated temperature. In this determination, when the actually measured temperature of the heat-generating part is higher than the estimated temperature by a predetermined threshold value or higher, it is determined that the cooling capability deterioration state is set, and the determination is correctly performed.

In this case, in a device embodying the present invention, the storing section stores a relationship between an operating rate of the heat-generating part and a temperature of the heat-generating part at a predetermined environmental temperature, and the temperature estimating section preferably corrects the relationship stored in the storing section on the basis of an actually measured temperature of the reference point and preferably calculates an estimated temperature of the heat-generating part corresponding to a current operating rate of the heat-generating part.

With the configuration, since only the relationship between an operating rate of the heat-generating part and the temperature of the heat-generating part at a predetermined environmental temperature may be stored, a storing capacity is saved.

When the storing capacity of the storing section has a margin, however, relationships between operating rates of the heat-generating part and temperatures of the heat-generating part in various environmental temperatures are stored, and an estimated temperature of the heat-generating part may be calculated without the correction with reference to a relationship corresponding to the measured temperature of the reference point.

An embodiment of the present invention comprises a computer in which a CPU which executes a program is built, and the CPU may be regarded as a heat-generating part.

A device embodying the present invention includes a display screen which displays an image, and the warning section may display an image expressing a warning on the display screen.

A cooling function monitoring apparatus having the characteristic configuration of an embodiment of the present invention may be used.

According to an embodiment of a second aspect of the present invention, there is provided a fan deterioration monitoring program storing medium which stores a fan deterioration monitoring program executed in a device which includes a heat-generating part generating heat in operation and a fan generating an air flow to air-cool the heat-generating part and executes a program, in which the fan deterioration monitoring program causing the device to operate as a device including:

a temperature estimating section which, using a relationship, stored in a storing section, between an operating rate of the heat-generating part and a temperature of the heat-generating part in a normal state of the fan, calculates an estimated temperature of the heat-generating part corresponding to a current operating rate of the heat-generating part on the basis of the relationship stored in the storing section and an actually measured temperature of a reference point separated from the heat-generating part;
a determining section which determines whether a cooling capability deterioration state is set on the basis of the actually measured temperature of the heat-generating part and the estimated temperature calculated by the temperature estimating section; and
a warning section which gives a warning to a user in response to a determination that the cooling capability deterioration state is set, the determination being made by the determining section. In this case, in the determination, when the actually measured temperature of the heat-generating part is higher than the estimated temperature by a predetermined threshold temperature or higher, it is determined that the cooling capability deterioration state is set, and the determination is correctly performed.

In the fan deterioration monitoring program storing medium according to an embodiment of a second aspect of the present invention,
the storing section stores a relationship between an operating rate of the heat-generating part and a temperature of the heat-generating part at a predetermined environmental temperature, and
the estimating section preferably corrects the relationship stored in the storing section on the basis of an actually measured temperature of a reference point measured by a temperature sensor and calculates an estimated temperature of the heat-generating part corresponding to a current operating rate of the heat-generating part.

Alternatively, as in a device embodying the present invention, when a storing capacity has a margin, relationships between operating rates of the heat-generating part and temperatures of the heat-generating part at various environmental temperatures are stored, an estimated temperature of the heat-generating part may be calculated without the correction with reference to a relationship corresponding to the measured temperature of the reference point.

A program storing medium which stores a fan deterioration monitoring program functioned as a cooling function monitoring apparatus having the characteristic configuration of an embodiment of the present invention may be used.

According to an embodiment of the present invention, deterioration of an air-cooling capability of a fan can be correctly detected. In particular, for a device which uses a heat-generating part the operating rate of which changes depending on a temperature, deterioration detection is correct.

BRIEF DESCRIPTION OF THE DRAWINGS

FIG. 1 is a graph showing a relationship between a temperature of a CPU and a rotating speed of a fan;
FIG. 2 is a diagram showing throttling of the CPU;
FIG. 3 is an external perspective view of a notebook personal computer according to an embodiment of a device according to the present invention;
FIG. 4 is a hardware block diagram of a notebook personal computer the appearance of which is shown in FIG. 3;
FIG. 5 is a schematic arrangement diagram in a main-body unit;
FIG. 6 is a graph showing a relationship between an operating rate and a temperature of the CPU; and
FIG. 7 is a flow chart showing a fan deterioration monitoring program.

DETAILED DESCRIPTION OF THE INVENTION

An embodiment of the present invention will be described below.

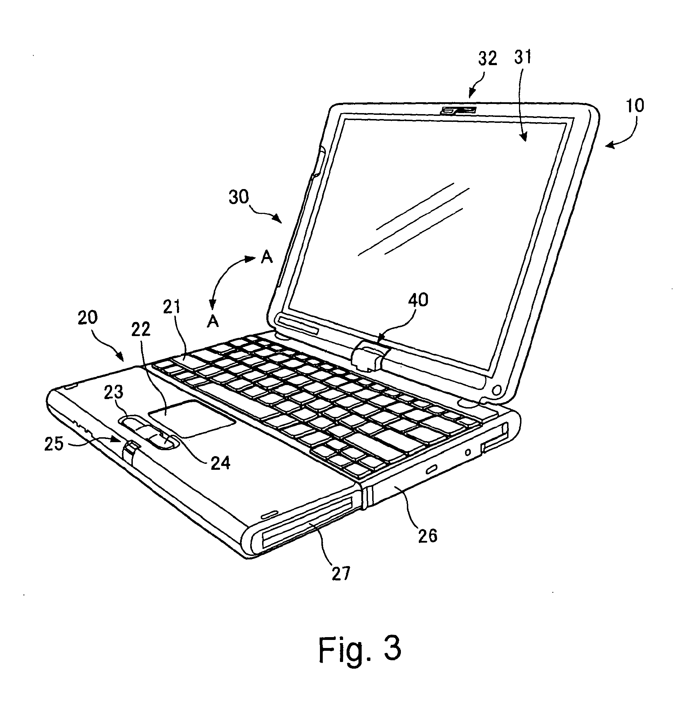

FIG. 3 is an external perspective view of a notebook personal computer (to be referred to as a "notebook PC" hereinafter) serving as an embodiment of a device according to the present invention.
The notebook PC 10 includes a main-body unit 20 and a display unit 30. The main-body unit 20 and the display unit 30 are connected by a connecting unit 40 such that the display unit 30 is openable/closable with respect to the main-body unit 20 in a direction of an arrow A - A. In FIG. 1 shows a notebook PC in a state in which the display unit 30 is opened with respect to the main-body unit 20.

In the main-body unit 20, on the upper surface, a keyboard 21, a track pad 22, a left-click button 23, a right-click button 24, and an engagement unit 25 which engages the display unit 30 when the display unit 30 is closed. On side surfaces of the main-body unit 20, a side surface 26 of an optical disk drive on which an optical disk such as a CD or a DVD is loaded to access the optical disk and an opening/closing lid 27 of an MO drive on which an MO is loaded to access the MO are exposed to the outer surface of main-body unit 20.

In the display unit 30 of the notebook PC 10, a large display screen 31 spreads on the front surface. A fastening unit 32 which is engaged with the engagement unit 25 of the main-body unit 20 when the display unit 30 is closed is arranged above the display screen 31.

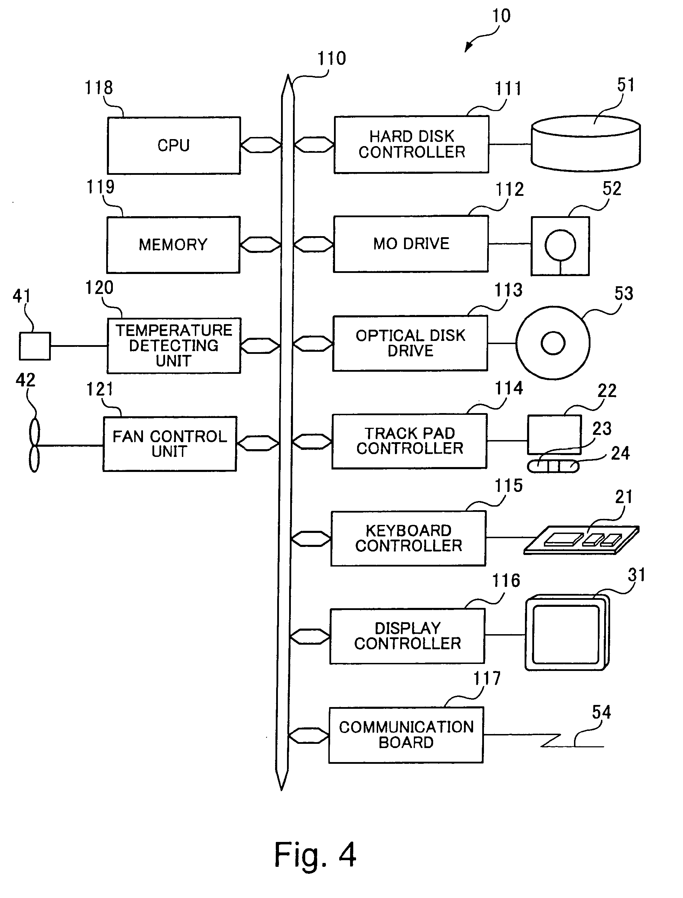

FIG. 4 is a hardware block diagram of the notebook PC the appearance of which is shown in FIG. 1.

In the hardware block diagram shown in FIG. 4, a hard disk controller 111, an MO drive 112, an optical disk drive 113, a track pad controller 114, a keyboard controller 115, a display controller 116, a communication board 117, a CPU 118, a memory 119, a temperature detecting unit 120, and a fan control unit 121 are shown. These components are connected to each other by a bus 110.

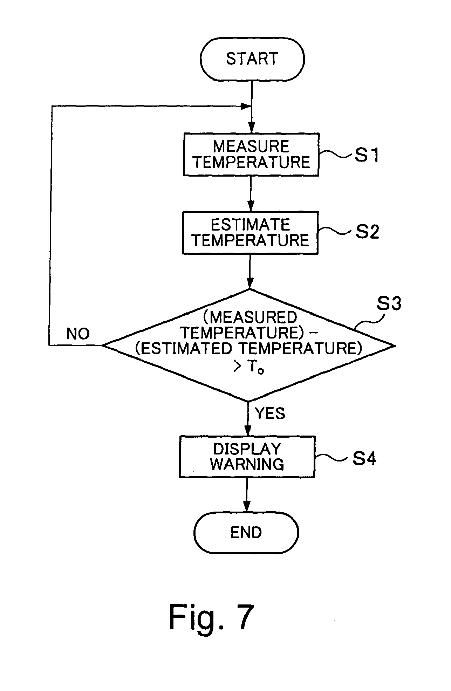

The hard disk controller 111 is a constituent element which serves to access a hard disk 51 built in the notebook PC 10. In the hard disk 51, an OS (operating system) executed in the notebook PC 10 and various application programs are stored. A fan deterioration monitoring program (will be described later with reference to FIG. 7) which is one of these programs is also stored in the hard disk 51.

The MO drive 112 serves to access an MO 52 loaded from the opening/closing lid 27 shown in FIG. 1. The optical disk drive 113 serves to access a loaded optical disk 53.

The track pad controller 114, the keyboard controller 115, and the display controller 116 serve to detect an operation of a track pad 22 (including the left-click button 23 and the right-click button 24), to detect an operation of the keyboard 21, and to control screen display on the display screen 31.

Furthermore, the CPU 118 serves to read a program stored in the hard disk 51, to develop the programs on the memory 119, and to execute the program developed on the memory 119. The CPU 118 is a circuit part with considerably high heat generation in operation.

In the main memory 119, the programs are developed as described above, and various data in execution of the programs in the CPU 118 are stored.

The temperature detecting unit 120 serves to detect a temperature by a temperature sensor 41 built in the main-body unit, and the fan control unit 121 serves to control rotation of the fan 42 arranged in the main-body unit.

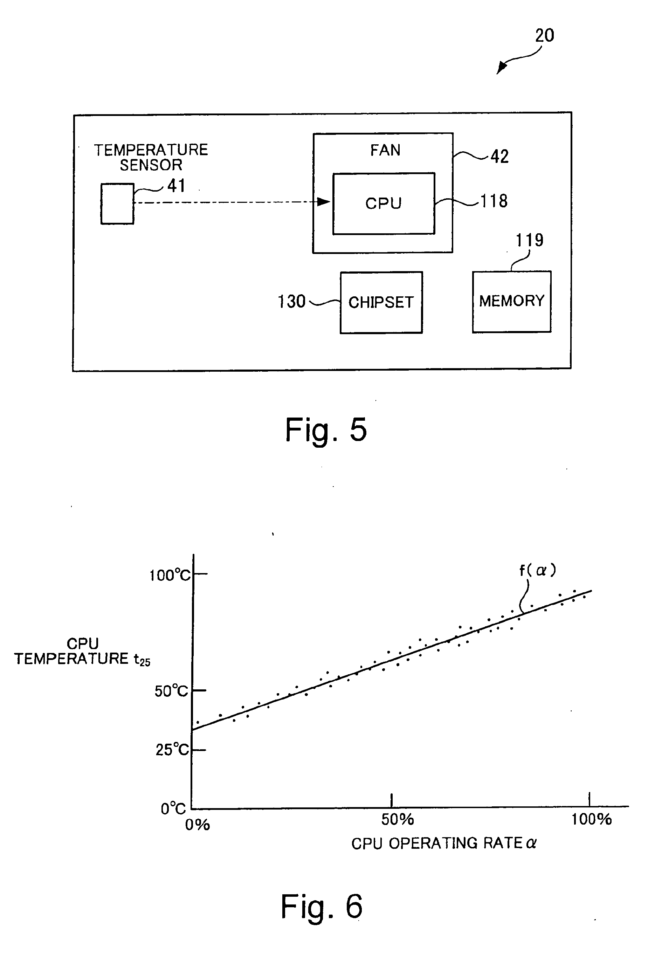

FIG. 5 is a schematic arrangement diagram of parts in the main-body unit 20. Only necessary parts are shown in the following explanation.

FIG. 5 shows, of parts built in the main-body unit, the CPU 118, the memory 119, a chipset 130, the fan 42, and the temperature sensor 41. The chipset 130 is a circuit part in which the track pad controller 114, the keyboard controller 115, the display controller 116, and the like are assembled.

As main heat-generating parts in the main-body unit 20, the CPU 118, the memory 119, the chipset 130 are regarded. In this case, an amount of heat generation of the CPU 118 is maximum, and the CPU 118 is most required to be cooled in relation to an operation guarantee temperature. For this reason, the fan 42 is arranged at such a position that the CPU 118 is concentrically cooled.

The temperature sensor 41 is placed at a position separated from the CPU 118. The temperature sensor 41 has a function that measures a temperature of the arrangement position (one example of a reference point according to an embodiment of the present invention) of the temperature sensor 41 and remotely measures a temperature of the CPU 118.

In the hard disk 51 shown in FIG. 4, a relationship between an operating rate of the CPU 118 and a temperature of the CPU 118 when the fan 42 is in a normal state is stored in advance. In execution of a fan deterioration monitoring program shown in FIG. 7 which will be described later, the relationship is read on the memory 119 and referred to. The notebook PC 10 is functioned as a control section the cooling function of which is monitored by the fan deterioration monitoring program.

FIG. 6 is a graph showing a relationship between an operating rate and a temperature of the CPU 118.

A line graph $f(\alpha)$ shown in FIG. 6 expresses a temperature $t_{25}$ of the CPU with respect to a CPU operating rate $\alpha$ when an environment temperature (outside air temperature of the notebook PC 10) is 25°C.

The line graph $f(\alpha)$ is measured for a typical notebook PC or several notebook PCs but measured for notebook PCs one by one. A graph obtained as an average measurement result is stored in all notebook PCs of the same type. A large number of dots shown in FIG. 6 indicate data in measurement, and only the graph $f(\alpha)$ is stored in a notebook PC.

FIG. 7 is a flow chart showing a fan deterioration monitoring program.

In this case, at first, temperature measurement is performed by the temperature sensor 41 (step S1). In this case, a temperature L at a position where the temperature sensor 41 is arranged and a temperature tremote of the CPU 118 are measured.

A temperature of the CPU 118 is estimated (step S2). In step S2 of the temperature estimation, an estimated temperature $F(\alpha)$ of the CPU is calculated by the following equation (1):

$$F(\alpha) = f(\alpha) + (L - C_{25}) \tag{1}$$

In this equation, $f(\alpha)$ denotes a value corresponding to a current operating rate $\alpha$ of the CPU in the graph shown in FIG. 6, and reference symbol L denotes a temperature at a position where the temperature sensor 41 is arranged. The line graph $f(\alpha)$ shown in FIG. 6 indicates a temperature of the CPU 118 when an environmental temperature outside the notebook PC 10 is 25°C. Since the temperature at the position where the temperature sensor 41 is arranged is different from the environmental temperature of 25° because the temperature sensor 41 is arranged inside the notebook PC 10, in order to correct an error of the estimated temperature of the CPU caused by the difference between the environmental temperature of 25°C and the temperature at the position where the temperature sensor 41 is arranged, a correction value $C_{25}$ is introduced to equation (1).

In step S3 in FIG. 7, a difference between the actually measured temperature tremote of the CPU and the estimated temperature $F(\alpha)$ of the CPU:

$$tremoto - F(\alpha)$$

is calculated, and it is determined whether the difference exceeds a threshold temperature $T_0$. When the difference does not exceeds the threshold temperature $T_0$, it is determined that a cooling capability deterioration state is not set, and the operation returns to step S1 to perform temperature measurement again. At the same time, temperature estimation based on a new operating rate of the CPU is performed.

As the operating rate $\alpha$ of the CPU, an operating rate at each moment is not employed, but an operation average value of time at a level equal to that of time when a temperature changes is employed.

On the other hand, in step S3, when the difference (tremote - $F(\alpha)$) exceeds the threshold temperature $T_o$ to determine that the cooling capability deterioration state is set, the operation shifts to step S4, a warning expressing that the cooling capability of the fan is deteriorated on the display screen 31 of the notebook PC 10 shown in FIG. 1.

A user who confirms the warning display cleans the fan to remove dust or dirt attaching around the fan, so that the deterioration of the cooling capability is expected to be eliminated.

According to the embodiment, deterioration of cooling capability of the fan is accurately determined, and appropriate information can be given to a user.

In the embodiment, only a relationship between an operating rate $\alpha$ of the CPU and a temperature of the CPU when an environmental temperature is 25°C is stored, and a temperature is estimated by using the relationship. However, relationships between operating rates of the CPU and temperatures of the CPU corresponding to different environmental temperatures are stored after the relationships are corrected by the correction value $C_{25}$, and an estimated temperature may be directly calculated from an actually measured temperature at a position where the temperature sensor 41 is arranged and an operating rate $\alpha$ of the CPU without an arithmetic operation of the equation (1).

In the embodiments above, a CPU is used as the heat-generating part. However, depending on arrangement positions, usages, or the like, when the memory 119 or the chipset 130 must be strongly cooled rather than the CPU 118, the same processes as described above may be performed by using the memory 119 or the chipset 130 as the heat-generating part.

Furthermore, embodiments of the present invention can be widely applied to not only a notebook PC but also other general devices such as a desktop personal computer.

**Claims**

1. A device having a heat-generating part which generates heat in operation and a fan which generates an air flow to air-cool the heat-generating part, comprising:

   a storing section in which a relationship between an operating rate of the heat-generating part and a temperature of the heat-generating part when the fan is in a normal state is stored;
   a temperature sensor which measures a temperature of the heat-generating part and a temperature of a reference point separated from the heat-generating part;

a temperature estimating section which calculates an estimated temperature of the heat-generating part corresponding to a current operating rate of the heat-generating part on the basis of the relationship stored in the storing section and an actually measured temperature of the reference point;

a determining section which determines whether a cooling capability deterioration state is set on the basis of an actually measured temperature of the heat-generating part measured by the temperature sensor and the estimated temperature calculated by the temperature estimating section; and

a warning section which gives a warning to a user in response to a determination that the cooling capability deterioration state is set, the determination being made by the determining section.

2. The device according to claim 1, wherein
the determining section determines the cooling ability deterioration state when the actually measured temperature of the heat-generating part measured by the temperature sensor is higher than the estimated temperature calculated by the temperature estimating section by a predetermined threshold temperature or higher.

3. The device according to claim 1 or 2, wherein
the storing section stores a relationship between an operating rate of the heat-generating part and a temperature of the heat-generating part at a predetermined environmental temperature, and
the temperature estimating section corrects the relationship stored in the storing section on the basis of an actually measured temperature of the reference point measured by the temperature sensor, and calculates an estimated temperature of the heat-generating part corresponding to a current operating rate of the heat-generating part on the basis of the corrected relationship.

4. The device according to claim 1, 2 or 3, wherein
the device is a computer in which a CPU which executes a program is built, and the CPU is used as the heat-generating part.

5. The device according to any preceding claim, comprising:

a display screen which displays an image, and wherein the warning section displays an image expressing a warning on the display screen.

6. A cooling function monitoring apparatus used in a device having a heat-generating part which generates heat in operation and a fan which generates an air flow to cool the heat-generating part, the cooling function monitoring apparatus comprising:

a temperature estimating section which, using a relationship, stored in a storing section, between an operating rate of the heat-generating part and a temperature of the heat-generating part in a normal state of the fan, calculates an estimated temperature of the heat-generating part corresponding to a current operating rate of the heat-generating part on the basis of the relationship stored in the storing section and an actually measured temperature of a reference point separated from the heat-generating part;

a determining section which determines whether a cooling capability deterioration state is set on the basis of the actually measured temperature of the heat-generating part and the estimated temperature calculated by the temperature estimating section; and

an output section which outputs a determination result obtained by the determining section.

7. A fan deterioration monitoring program storing medium which stores a fan deterioration monitoring program executed in a device which includes a heat-generating part generating heat in operation and a fan generating an air flow to air-cool the heat-generating part and executes a program, the fan deterioration monitoring program causing the device to operate as a device comprising:

a temperature estimating section which, using a relationship, stored in a storing section, between an operating rate of the heat-generating part and a temperature of the heat-generating part in a normal state of the fan, calculates an estimated temperature of the heat-generating part corresponding to a current operating rate of the heat-generating part on the basis of the relationship stored in the storing section and an actually measured temperature of a reference point separated from the heat-generating part;

a determining section which determines whether a cooling capability deterioration state is set on the basis of the actually measured temperature of the heat-generating part and the estimated temperature calculated by the temperature estimating section; and

a warning section which gives a warning to a user in response to a determination that the cooling capability deterioration state is set, the determination being made by the determining section.

8. The fan deterioration monitoring program storing medium according to claim 7, storing the fan deterioration monitoring program causing:

the determining section to determine that the cooling capability deterioration state is set when the actually measured temperature measured by the temperature sensor is higher than the estimated temperature calculated by the temperature estimating section by a predetermined threshold value or higher.

9. The fan deterioration monitoring program storing medium according to claim 7 or 8, storing the fan deterioration monitoring program causing:

the storing section to store a relationship between an operating rate of the heat-generating part and a temperature of the heat-generating part at a predetermined environmental temperature; and
the temperature estimating section to correct the relationship stored in the storing section on the basis of a actually measured temperature of the reference point measured by the temperature sensor, and to calculate an estimated temperature of the heat-generating part corresponding to a current operating rate of the heat-generating part on the basis of a corrected relationship.

10. A fan deterioration monitoring program storing medium which stores a fan deterioration monitoring program executed in a device which includes a heat-generating part generating heat in operation and a fan generating an air flow to air-cool the heat-generating part and executes a program, the fan deterioration monitoring program causing the device to operate as a cooling function monitoring apparatus comprising:

a temperature estimating section which, using a relationship, stored in a storing section, between an operating rate of the heat-generating part and a temperature of the heat-generating part in a normal state of the fan, calculates an estimated temperature of the heat-generating part corresponding to a current operating rate of the heat-generating part on the basis of the relationship stored in the storing section and an actually measured temperature of a reference point separated from the heat-generating part;
a determining section which determines whether a cooling capability deterioration state is set on the basis of the actually measured temperature of the heat-generating part and the estimated temperature calculated by the temperature estimating section; and
an output section which outputs a determination result obtained by the determining section.

Fig. 1

Fig. 2

Fig. 3

110

10

118
CPU

111
HARD DISK
CONTROLLER

51

119
MEMORY

112
MO DRIVE

52

41

120
TEMPERATURE
DETECTING
UNIT

113
OPTICAL DISK
DRIVE

53

42

121
FAN CONTROL
UNIT

114
TRACK PAD
CONTROLLER

22
23
24

115
KEYBOARD
CONTROLLER

21

116
DISPLAY
CONTROLLER

31

117
COMMUNICATION
BOARD

54

# Fig. 4

20

TEMPERATURE
SENSOR

FAN ~42

41

CPU ~118

119

130 ~ CHIPSET

MEMORY

# Fig. 5

100°C

f($\alpha$)

CPU
TEMPERATURE $t_{25}$

50°C

25°C

0°C

0%          50%          100%

CPU OPERATING RATE $\alpha$

# Fig. 6

EP 1 835 377 A2

Fig. 7

13

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 3203395 A
- JP 2004027987 A
- JP 2002058280 A